# EUROPEAN PATENT APPLICATION

(11) **EP 4 220 710 A1**
(43) Date of publication of application: **02.08.2023**
(21) Application number: 23153362.1
(22) Date of filing: 26.01.2023
(51) Int. Cl.: H01L 23/538, G02B 6/42, G02B 6/43, H01L 23/14, H01L 23/498, H01L 25/065, H01L 23/00

(54) **MODULE COMPRISING A SEMICONDUCTOR-BASED COMPONENT AND METHOD OF MANUFACTURING THE SAME**

(30) Priority: 28.01.2022 CN 202210107360
(71) Applicant: AT & S Austria Technologie & Systemtechnik Aktiengesellschaft, 8700 Leoben-Hinterberg (AT)
(72) Inventor: Mok, Jeesoo, Chongqing, 401120 (CN)
(74) Representative: Dilg, Haeusler, Schindelmann Patentanwaltsgesellschaft mbH

(57) **Abstract**

An module (1) according to the present invention comprises a component carrier (2) with a stack comprising at least one electrically conductive layer structure (3) and/or at least one electrically insulating layer structure (4), and with a semiconductor-based bridging component (5) embedded in the stack and having a redistribution structure; and an electronic component (6) mounted on the component carrier (2) and being partially electrically connected with the semiconductor-based component (5) and partially electrically connected with another element (7, 8) of the component carrier (2) or the module (1).

## Description

The invention relates to a module comprising a semiconductor-based component and to a method of manufacturing the same.

A fan-out wafer level packaging (FOWLP) is one of the latest packaging trends in microelectronics. It has high potential for significant package miniaturization concerning package volume on the one hand, but results to a certain module thickness on the other hand. Technological core of FOWLP is a formation of a reconfigured molded wafer combined with a thin film redistribution layer to yield an SMD-compatible package. Main advantages of FOWLP are a substrate-less package, a low thermal resistance, an improved RF performance due to shorter interconnects together with a direct IC connection by thin film metallization instead of wire bonds or flip chip bumps and lower parasitic effects. It can be used for multi-chip packages for system-in-package (SiP) solutions and heterogenous integration.

For higher productivity and lower costs, larger mold embedding form factors are needed, which conventionally results in an increased wafer diameter.

There may be an object for providing an electric module which can be manufactured with higher yield and exhibits less shrinkage-involved problems, wherein a delamination of inner layers can be avoided. This object is achieved by the subject matters of the independent claims. The present invention is further developed as set forth in the dependent claims.

According to a first aspect of the invention, a module comprises a component carrier with a stack comprising at least one electrically conductive layer structure and/or at least one electrically insulating layer structure, and with at least one bridging component embedded in the stack and having a redistribution structure. The bridging component comprises a first main surface and a second main surface, one opposite to the other, with first contacting areas provided on said first main surface and second contacting areas provided on said second main surface, said first contacting areas being connected to said second contacting areas through respective connection elements provided in said bridging component. At least one of said first or second contacting area is directly or indirectly connected to at least two electronic components.

The bridging component may comprise materials such as a semiconductor-based material, a matrix, e.g. silicon, glass, ceramics or a resin material. The bridging component could be manufactured at least partially by a NIL process (nanoimprint lithography process).

The first contacting areas can be first electrically conductive redistribution structures or pads, and the second contacting areas can be second electrically conductive redistribution structures or pads. The connection elements can be interconnected vertical structures, preferably arranged between interconnected horizontal structures or layers.

The bridging component can be formed without any organic build-up layer. Since the bridging component, which preferably does not have any organic layer, can have the same or a similar CTE (coefficient of thermal expansion) like the electronic component or the other element, which can be attached above for example by solder balling, shrinkage-involved problems of the module within a horizontal plane of the module can be reduced or minimized compared with the prior art, where the organic layers are involved. For example, warpage of the module can be reduced. A possible bonding problem among inner layers can be also decreased to avoid problems involved by delamination. For example, the following CTE value can be used:
- core layer 5-12 ppm/K
- organic layers (e.g. ABF material) 8-12 ppm/K
- copper 17 ppm/K
- silicon 2-3 ppm/K
- ceramic 8-12 ppm/K.

In an embodiment, the component carrier comprises two component carrier main surfaces, each bridging component main surface are respectively directly connected to the component carrier main surfaces.

In an embodiment, solder balls are provided on at least one of the component carrier main surfaces, said solder balls being directly or indirectly connected to at least one of the first or second contacting area of the respective bridging component main surface.

In an embodiment, a density, for example per volume unit or area unit, of a contacting area of the bridging component first main area is different than a density of a contacting area of the bridging component second main area.

In an embodiment, a density of the contacting area of the bridging component main surface, which is directly connected to at least one of the two electronic components, is higher than a density of the contacting area provided on the opposed bridging component main surface.

In an embodiment, said component carrier comprises at least two bridging components embedded in the stack.

In an embodiment, at least one of the at least two electronic components mounted on the component carrier is connected to the at least two bridging components.

In an embodiment, the at least one of the at least two electronic components is connected to each first main surface of the at least two bridging components facing the same component carrier main surface.

In an embodiment, said bridging component is connected to a third electronic component.

In an embodiment, said bridging component is connected to the third electronic component via the first main surface.

In an embodiment, at least one of the two electronic components is additionally connected to a further redistribution structure directly provided in said component carrier.

In an embodiment, at least one of the two electronic components is exclusively connected to said at least one bridging component.

In an embodiment, wherein, at least one of the two electronic components is partially connected to said bridging component.

In an embodiment, at least one of the two electronic components is connected to a power conducting supplying structure for power supply to the at least one of the two electronic components. For example, the power conducting supplying structure may preferably be used to provide electric power to the electric components since fine electrically conductive traces inside the bridging component may not be feasible to withstand high current densities (e.g., >100 A/cm² which is a current density, i.e., a current per area. This may particularly be useful when an electrical component is connected to at least two bridging components and when it has to use higher electric power.

The at least one of the two electronic components can also be connected to a structure for signal transmission between the component carrier and the electronic component.

In an embodiment, the bridging component comprises a matrix of dielectric or semiconductor material and the connection elements embedded in the matrix, which form the electrically conductive redistribution structure together with the first and second contacting areas, wherein a mean distance between the first contacting areas is different to a mean distance between the second contacting areas.

In an embodiment, the connection elements comprise at least two first horizontal electrically conductive redistribution structures in an x direction, at least two second horizontal electrically conductive redistribution structures in an y direction, and at least two vertical electrically conductive redistribution structures in a z direction, wherein at least one of said first and second electrically conductive redistribution structures is electrically connected to at least one vertical electrically conductive redistribution structure.

In an embodiment, the module comprises at least one of the following features: a mean distance between two first horizontal electrically conductive redistribution structures in the x direction is different from a mean distance between two second horizontal electrically conductive redistribution structures the in the y direction and/or different from a mean distance between two vertical electrically conductive redistribution structures in the z direction; and/or a mean distance between two second horizontal electrically conductive redistribution structures in the y direction is different from a mean distance between two vertical electrically conductive redistribution structures in the z direction. For example, the matrix of the bridging component comprises at least one shared common surface area with the conductive redistribution structures in an x-y-plane, an x-z-plane and/or an y-z plane; at least one electrically conductive area, which is parallel to main surface areas and/or spatially extends into the x direction and/or the y direction; and/or completely embedded conductive redistribution structures.

In an embodiment, the module comprising a mounting base on which the component carrier is mounted.

In an embodiment, the module further comprises a mold encapsulating the electronic component.

In an embodiment, the bridging component and a further bridging component, both are preferably two bridging components, are arranged side by side in the stack at the same vertical level.

In an embodiment, the bridging component is configured to supply electric power to the electronic component.

In an embodiment, the electronic component comprises at least one of a group consisting of a processor, a memory, a passive component, and a power chip.

In an embodiment, the component carrier comprises at least one of the following features: the component carrier comprises at least one component being surface mounted on and/or embedded in the component carrier, wherein the at least one component is in particular selected from a group consisting of an electronic component, an electrically non-conductive and/or electrically conductive inlay, a heat transfer unit, a light guiding element, an optical element, a bridge, an energy harvesting unit, an active electronic component, a passive electronic component, an electronic chip, an RF chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip; wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene; wherein the electrically insulating layer structure comprises at least one of the group consisting of resin, in particular reinforced or non-reinforced resin, for instance epoxy resin or bismaleimide-triazine resin, FR-4, FR-5, cyanate ester resin, polyphenylene derivate, glass, prepreg material, polyimide, polyamide, liquid crystal polymer, epoxy-based build-up film, polytetrafluoroethylene, a ceramic, and a metal oxide; wherein the component carrier is shaped as a plate; wherein the component carrier is configured as one of the group consisting of a printed circuit board, a substrate, and an interposer; wherein the component carrier is configured as a laminate-type component carrier.

According to a second aspect of the invention, a method of manufacturing a module is provided. The method comprises: providing a component carrier with a stack comprising at least one electrically conductive layer structure and/or at least one electrically insulating layer structure, and with at least one bridging component embedded in the stack and having a redistribution structure. The bridging component comprises a first main surface and a second main surface, one opposite to the other, with first contacting areas provided on said first main surface and second contacting areas provided on said second main surface, said first contacting areas being connected to said second contacting areas through respective connection elements provided in said bridging component. At least one of said first or second contacting area is directly or indirectly connected to at least two electronic components.

In an embodiment,the method is carried out on panel level.

The method can be carried out by the "chip last" principle, where the electronic component and the other element can be attached to the component carrier after having embedded the bridging component therein. Such "chip last" procedure enables a higher yield in Fan-Out Panel-Level Packaging (FO-PLP) without organic build up processes, and a simple manufacturing process.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. A component carrier may comprise a laminated layer stack. In particular, a component carrier may be one of a printed circuit board, an organic interposer, and an IC (integrated circuit) substrate. A component carrier may also be a hybrid board combining different ones of the above-mentioned types of component carriers.

In an embodiment, bridging signals between other components can be used via the bridging component which acts as a bridging device.

In the context of the present application, the term "stack" may particularly denote an arrangement of multiple planar layer structures which are mounted in parallel on top of one another.

In the context of the present application, the term "layer structure" may particularly denote a continuous layer, a patterned layer or a plurality of nonconsecutive islands within a common plane.

In the context of the present application, the term "electronic component" may particularly denote a component fulfilling an electronic task. For instance such an electronic component may be a semiconductor chip comprising a semiconductor material, in particular as a primary or basic material. The semiconductor material may for instance be a type IV semiconductor such as silicon or germanium, or may be a type III-V semiconductor material such as gallium arsenide or indium phosphide. In particular, the semiconductor component may be a semiconductor chip such as a naked die or a molded die.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF), and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, platinum, titanium, carbon and (doped) silicon. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, an RF chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, an energy harvesting unit, and an RF chip. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a module according to an exemplary embodiment of the invention.
Figure 2 illustrates a cross-sectional view of a module according to an exemplary embodiment of the invention.
Figure 3 illustrates a cross-sectional view of a module according to an exemplary embodiment of the invention.
Figure 4 illustrates a method of manufacturing a module according to an exemplary embodiment of the invention.
Figure 5 illustrates the method of manufacturing the module according to the exemplary embodiment of the invention.
Figure 6 illustrates a cross-sectional view of semiconductor-based bridging component according to an exemplary embodiment of the invention.
Figure 7 illustrates a cross-sectional view of a module according to an exemplary embodiment of the invention.
Figure 8 illustrates a cross-sectional view of a module according to an exemplary embodiment of the invention.

The illustrations in the drawings are schematic. In different drawings, similar or identical elements are provided with the same reference signs.

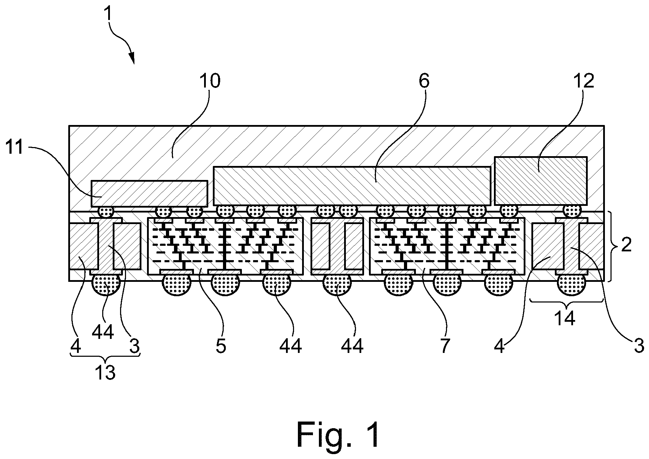

Figure 1 illustrates a cross-sectional view of a module 1 according to an exemplary embodiment of the invention. The module 1 comprises a component carrier 2 with a stack comprising at least one electrically conductive layer structure 3 and at least one electrically insulating layer structure 4. The at least one electrically conductive layer structure 3 can comprise at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one electrically insulating layer structure 4 can comprise at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoro-ethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

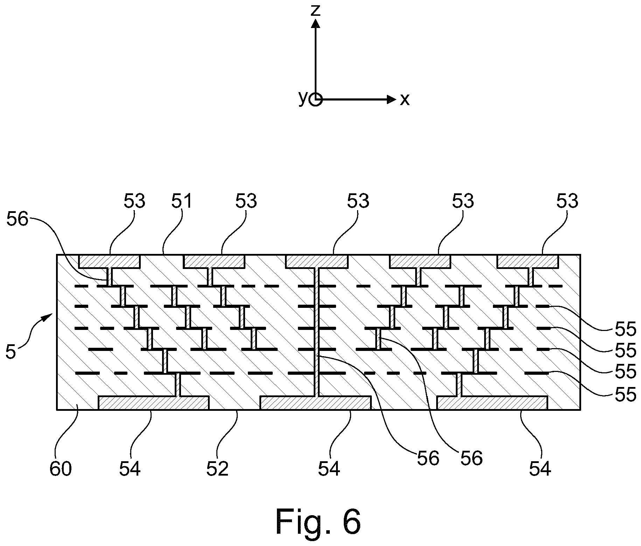

The module 1 further comprises a semiconductor-based bridging component 5 embedded in the stack and having a redistribution structure, which is later described in more detail in Fig. 6. The semiconductor-based bridging component 5 can comprise a matrix of semiconductor material and electrically conductive redistribution structures embedded in the matrix. The semiconductor-based bridging component 5 can act as an electrically insulating material. If the semiconducting material is slightly doped, it shows electrically conductive behavior and the entire bridging component 5 (or a further semiconductor-based bridging component 7 which is described later) is electrically conductive resulting in that the copper traces inside are useless. In addition, the electrically conductive redistribution structures can comprise interconnected horizontal and vertical structures. Preferably, the electrically conductive redistribution structures form an electrically conductive path between a first (top) main surface having a first pitch, and a second (bottom) main surface having a second pitch, the second pitch being larger than the first pitch. The first and second pitches are for example horizontal center-to-center distances of the electrically conductive redistribution structures at the respective main surface.

The module 1 further comprises an electronic component 6 such as a die, which is mounted on the component carrier 2, encapsulated by a mold 10, partially electrically connected with the semiconductor-based bridging component 5, and partially electrically connected with another element 7 of the component carrier 2. The electronic component 6 can comprise at least one of a group consisting of a processor, a memory, a passive component, and a power chip.

In the embodiment of Fig. 1, the other element 7 comprises a further semiconductor-based bridging component 7 having a further redistribution structure. The semiconductor-based bridging component 5 and the further semiconductor-based bridging component 7 are arranged side by side in the stack at the same vertical level. The semiconductor-based bridging component 5 and the further semiconductor-based bridging component 7 can be identical or different from each other. At least one of the semiconductor-based bridging component 5 and the further semiconductor-based bridging component 7 can be configured to supply electric power or for a signal transmission to the electronic component 6.

The module 1 further comprises a further electronic component 11, such as a die, mounted on the component carrier 2 and being partially electrically connected with the semiconductor-based bridging component 5 and partially electrically connected with another element 13 of the component carrier 2. In the embodiment of Fig. 1, the other element 13 is part of the stack and comprises an electrically conductive layer structure 3 in the shape of a via.

In addition, the module 1 further comprises another further electronic component 12, such as a die, mounted on the component carrier 2 and being partially electrically connected with the further semiconductor-based bridging component 7 and partially electrically connected with a further other element 14 of the component carrier 2. In the embodiment of Fig. 1, the further other element 14 is part of the stack and comprises an electrically conductive layer structure 3 in the shape of a via.

The electronic component 6, the further electronic component 11 and the other further electronic component 12 are mounted to the component carrier 2 via first solder balls 43 such as first bumps 43 which provide an electrical and a mechanical connection between the electrically conductive redistribution structures at the (top) first main face 51 of the semiconductor-based bridging component 5 and the component 6, the further electronic component 11 and the other further electronic component 12. The electronic component 6, the further electronic component 11 and the other further electronic component 12 are partially mounted above the first main surface 51 of the semiconductor-based bridging components 5 and/or 7.

The first solder balls 43 are in a direct contact with the bridging component 5 and the electronic component 6, the further electronic component 11 and the other further electronic component 12, or in an indirect contact therewith, which means that some electrically conductive structures (e.g. vias/copper pillars) are between the solder balls 43 and the bridging component 5 and/or between the solder balls 43 and the electronic component 6, the further electronic component 11 and the other further electronic component 12.

The semiconductor-based bridging component 5 can be configured to supply electric power or to transmit signals to the electronic component 6 and the further electronic component 11. The further semiconductor-based bridging component 7 can be configured to supply electric power or to transmit signals to the electronic component 6 and the other further electronic component 12.

The module 1 comprises second solder balls 44 such as second bumps at the front side, the second main surface 52, for example to provide terminals for a power supply and a data/address bus, or for filtering signals. The second bumps 44 provide an electrical and a mechanical connection between the electrically conductive redistribution structures at the bottom main face of the semiconductor-based bridging components 5 and/or 7 and another periphery. As described above, a pitch of the second bumps 44 is larger than a pitch of the first bumps 43.

Although not shown in Fig. 1, the module 1 can comprise a mounting base, for example a PCB or another component carrier, on which the component carrier 2 is mounted, for example via the second bumps 44.

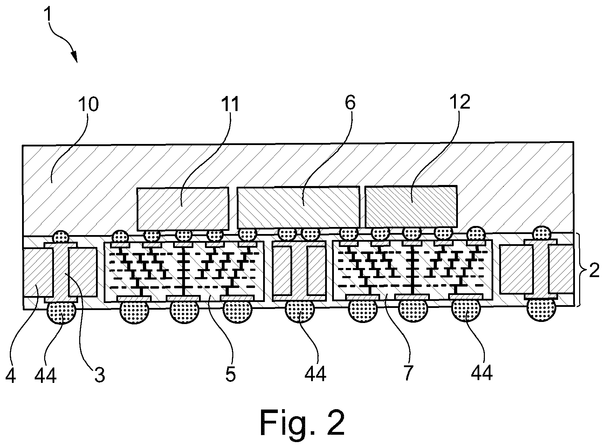

Figure 2 illustrates a cross-sectional view of a module 1 according to an exemplary embodiment of the invention. The embodiment of Fig. 2 is like the embodiment of Fig. 1 except for some differences as described below. The module 1 further comprises a further electronic component 11 mounted on the component carrier 2 and being partially electrically connected with the semiconductor-based bridging component 5. In the embodiment of Fig. 2, the further electronic component 11 is a first processor. In addition, the module 1 further comprises another further electronic component 12 mounted on the component carrier 2 and being partially electrically connected with the further semiconductor-based bridging component 7. In the embodiment of Fig. 2, the other further electronic component 12 is a second processor. The module 1 has a symmetric layout with regard to a vertical center axis. If more than three components are included, there is also the possibility to use power management integrated circuits (PMIC), or Logic chip processors, PMIC, RF, etc.

Between the further electronic component 11 and the other further electronic component 12, an electronic component 6 is mounted to the component carrier 2. The electronic component 6 can be a memory.

The semiconductor-based bridging component 5 can be configured to supply electric power or to transmit signals to the electronic component 6 and the further electronic component 11. The further semiconductor-based bridging component 7 can be configured to supply electric power to the electronic component 6 and the other further electronic component 12.

In this embodiment, the semiconductor-based bridging component 5 is larger than the electronic component 6, the further electronic component 11 and the other further electronic component 12. The semiconductor-based bridging component 5 connects the electronic component 6 (for example the memory) to the further electronic component 11 (for example the first processor). The further semiconductor-based bridging component 7 connects the electronic component 6 (for example the memory) to the other further electronic component 12 (for example the second processor).

The second bumps 44 at the front side can provide terminals for a power supply and a data/address bus.

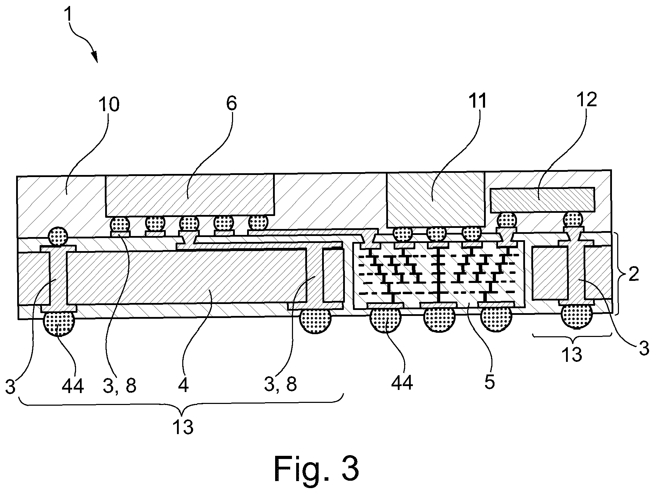

Figure 3 illustrates a cross-sectional view of a module 1 according to an exemplary embodiment of the invention. The embodiment of Fig. 3 is like the embodiment of Fig. 1 except for some differences as described below. For example, the electronic component 6 can be a memory. The electronic component 6 is partially electrically connected with the semiconductor-based bridging component 5, but not arranged directly above the semiconductor-based bridging component 5. The electronic component 6 is partially electrically connected with another element 8 in the shape of electrically conductive layer structures 3 of the stack, for example in the shape of a via within the stack or a conductive trace on the stack.

The module 1 further comprises a further electronic component 11 mounted on the component carrier 2 and being partially electrically connected with the semiconductor-based bridging component 5. The further electronic component 11 can be a processor or logic processor.

In addition, the module 1 further comprises another further electronic component 12 mounted on the component carrier 2 and being partially electrically connected with the semiconductor-based bridging component 5 and partially electrically connected with another element 13 of the component carrier 2. In the embodiment of Fig. 3, the other element 13 is part of the stack and comprise an electrically conductive layer structure 3 in the shape of a via. The other further electronic component 12 can be a passive component such as a capacitor or an active component like PMIC.

Unlike the embodiments of Figures 1 and 2, the module 1 of the embodiment of Fig. 3 does not comprise any further semiconductor-based bridging component 7. The single semiconductor-based bridging component 5 can be configured to supply electric power or to transmit signals to the electronic component 6, the further electronic component 11, and the other further electronic component 12.

In this embodiment, the semiconductor-based bridging component 5 is larger than the further electronic component 11 (for example the processor) and connects the further electronic component 11 to the electronic component 6 (for example the memory).

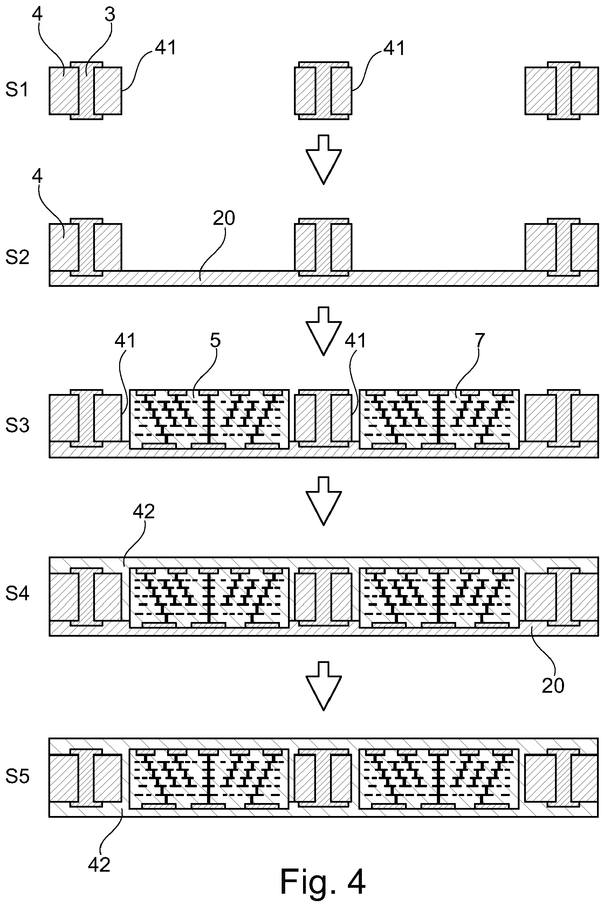

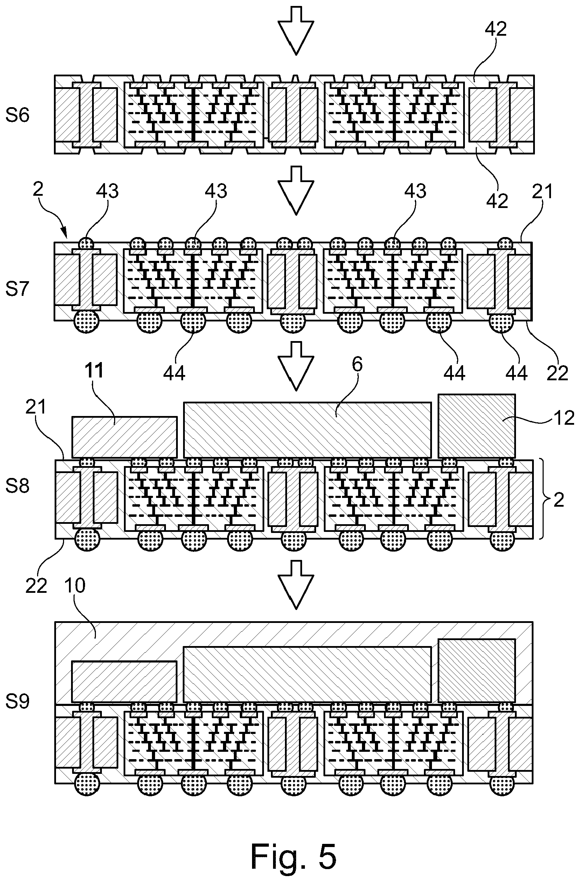

Figures 4 und 5 illustrate a method of manufacturing a module 1 according to an exemplary embodiment of the invention. In a step S1, an electrically insulating layer structure 4 in the shape of a core is provided. One or more cavities 41 are provided into the electrically insulating layer structure 4. The electrically insulating layer structure 4 can be made of an organic material, inorganic materials such as silicon, ceramics, a glass material, a metal material, etc. Metals with extremely low electric conductivities below 10⁻⁹ S/cm as well as ceramic materials can also be used. The electrically insulating layer structure 4 can be provided with vias, for example copper-filled vias which form electrically conductive layer structures 3.

In a step S2, a temporary carrier 20 is attached to a bottom main surface of the electrically insulating layer structure 4 (which is a core in this embodiment).

In a step S3, a semiconductor-based bridging component 5 and a further semiconductor-based bridging component 7 are embedded into the respective cavities 41. The semiconductor-based bridging component 5 and the further semiconductor-based bridging component 7 are adhered to the temporary carrier 20.

In a step S4, a top- or back-side lamination is performed, wherein a curable photo-imageable dielectric (PID) 42 fills the spacings in the cavities 41 between the electrically insulating layer structure 4 and the semiconductor-based bridging component 5 and the further semiconductor-based bridging component 7, respectively. When the photo-imageable dielectric (PID) 42 is cured, e.g., by elevated temperatures or electromagnetic irradiation, the semiconductor-based bridging component 5 and the further semiconductor-based bridging component 7 are held in place within the respective cavity 41.

PID is a photo-imageable dielectric which becomes soluble, when being exposed to electromagnetic waves (usually UV light), or heat. After developing, the recesses are created in a positive photo process. During exposing negative PID's by UV light or heat, a crosslinking process occurs, which with the result that those parts/areas get insoluble. Advantageously, the first contacting areas 51 of the semiconductor based bridging component 5 can be detected, e.g., by x-ray cameras, and the recesses and following electrical connections could be created with very high reliability. The component carrier 2 consists of a fully cured (glass fiber) reinforced core layer as the electrically insulating layer structure 4 and the positive PID layer 42.

The added resin layer does not necessarily comprise the PID layer 42. It could be any resin layer (epoxide, polyimide, Teflon, etc.) which could be further processed by a subtractive process. Creation of the recesses could be done by physical or chemical etching.

In an embodiment, a nanoimprint lithography (NIL) process is used. While using the techniques such as the PID or NIL, thinner and more reliable structures can be created, e.g., copper traces which are thinner than 5µm, preferably thinner than 2µm, more preferred thinner than 1µm. This may be needed when the pitch size of the first main surface 51 of the semiconducting bridging component 5 is small and lot of fine traces have to be redistributed.

In a step S5, the temporary carrier 20 is removed, and a bottom- or front-side lamination is performed, wherein a curable photo-imageable dielectric (PID) 42 fills the remaining spacings in the cavities 41 between the electrically insulating layer structure 4 and the semiconductor-based bridging component 5 and the further semiconductor-based bridging component 7, respectively.

In a step S6, the photo-imageable dielectric (PID) 42 at the front end and the back end are patterned, for example by means of SRSF (Solder Resist process), a Surface Finish process such as ENIG, ENEPIG, or BE (Back-End process) such as Bumping, Routing, E-test and so on. Subtractive processes are also possible.

In a step S7, first bumps 43 and second bumps 44 are provided at the back (top) end and the front (bottom) end. The pitch of the first bumps 43 at the back end is smaller than a pitch of the second bumps 44 at the front end. The intermediate product after step S7 (or even after step S6, if the component carrier 2 shall not be provided with the bumps 43, 44) forms a component carrier 2. The component carrier 2 including the semiconductor-based bridging component 5 according to the present invention exhibits, for packaging purposes, an improved shrinkage performance within a horizontal plane and shrinkage related performances and the bonding performances of the inner layers compared to a prior art organic component carrier. The first bumps 43 having the smaller pitch at the back end enable a stable chip assembly. The component carrier 2 comprises two component carrier main surfaces 21, 22, wherein bridging component main surface 51, 52 (see Fig. 6) of the bridging component 5 are respectively directly connected to the component carrier main surfaces 21, 22.

In a step S8, an electronic component 6, a further electronic component 11, and another further electronic component 12 are attached to the component carrier 2, for example by die bonding. This procedure is referred as "chip last", where the electronic component 6 and the other component 11 can be attached to the component carrier 2 after having embedded the semiconductor-based bridging component 5 therein. Such "chip last" procedure enables a higher yield in Fan-Out Panel-Level Packaging (FO-PLP) without organic build up processes, and a simple manufacturing process.

Such "chip last" procedure enables a higher yield in Fan-Out Panel-Level Packaging (FO-PLP) without organic build up processes, and a simple manufacturing process. The electronic component 6, the further electronic component 11, and the other further electronic component 12, which can be dies, can be attached in a stable manner, in particular by the first bumps 43 having a fine pitch.

In a step S9, the electronic component 6, the further electronic component 11, and the other further electronic component 12 are over-mold by a mold 10. Optionally, the back side of the module 1 can be ground to get access to silicon for improved cooling. Such grounded module 1 is shown in the embodiment of Fig. 3, where the electronic component 6 (memory) and the further electronic component 11 (processor) are exposed at the back side of the module 1.

As shown in Figures 4 and 5, the method of manufacturing the module 1 is carried out on panel level, i.e., the method of manufacturing the module 1 is not carried out on wafer level.

Figure 6 illustrates a cross-sectional view of semiconductor-based bridging component 5 according to an exemplary embodiment of the invention. The semiconductor-based bridging component 5 comprises a first (top) main face 51 and a second (bottom) main face 52. The first main face 51 comprises first contacting areas 53 such as first electrically conductive redistribution structures or pads, and the second main face 52 comprises second contacting areas 54 such as second electrically conductive redistribution structures or pads. The semiconductor-based bridging component 5 comprises inside a matrix 60 of semiconductor material and inner electrically conductive redistribution structures 55, 56 embedded in the matrix. The electrically conductive redistribution structures 53, 54, 55, 56 form an electrically conductive path between the first main surface 51 having a first pitch, and the second main surface 52 having a second pitch, the second pitch being larger than the first pitch. The first and second pitches are for example horizontal center-to-center distances of the electrically conductive redistribution structures or pads 53, 54 at the respective main surface 51, 52. In addition, the electrically conductive redistribution structures comprise interconnected horizontal structures 55 and connection elements 56 such as interconnected vertical structures.

Preferably, the semiconductor-based bridging component 5 forms a silicon-build-up structure without organic build-up layers. Since the semiconductor-based bridging component 5, which preferably does not have any organic layer, can have the same or a similar CTE (coefficient of thermal expansion) like the electronic component 6 or the other component 11, which can be attached above for example by solder balling, shrinkage-involved problems of the module 1 within a horizontal plane of the module 1 can be reduced or minimized compared with the prior art, where the organic layers are involved. For example, warpage of the module 1 can be reduced.

As a result, the module 1 comprises the component carrier 2 with the stack comprising at least one electrically conductive layer structure 3 and/or at least one electrically insulating layer structure 4, and with the at least one bridging component 5 embedded in the stack and having the redistribution structure. The bridging component 5 comprises the first main surface 51 and the second main surface 52, one opposite to the other, with the first contacting areas 53 provided on the first main surface 51, and the second contacting areas 54 provided on the second main surface 52, wherein the first contacting areas 53 are connected to the second contacting areas 54 through the respective connection elements 55, 56 provided in the bridging component 5. At least one of said first or second contacting area 53, 54 is directly or indirectly connected to the at least two electronic components 6, 11, 12.

Further, the bridging component 5 comprises the matrix 60 of dielectric or semiconductor material and the connection elements 55, 56 embedded in the matrix, which form the electrically conductive redistribution structure together with the first and second contacting areas 53, 54, wherein a mean distance between the first contacting areas 53 is different to a mean distance between the second contacting areas 54. The connection elements 55, 56 comprise at least two first horizontal electrically conductive redistribution structures 55 in an x direction, at least two second horizontal electrically conductive redistribution structures in an y direction, and at least two vertical electrically conductive redistribution structures 56 in a z direction; at least one of said first and second electrically conductive redistribution structures is electrically connected to at least one vertical electrically conductive redistribution structure.

A mean distance between two first horizontal electrically conductive redistribution structures 55 in the x direction is different from a mean distance between two second horizontal electrically conductive redistribution structures the in the y direction and/or different from a mean distance between two vertical electrically conductive redistribution structures in the z direction; and/or a mean distance between two second horizontal electrically conductive redistribution structures in the y direction is different from a mean distance between two vertical electrically conductive redistribution structures in the z direction.

The matrix 60 of the bridging component 5 comprises at least one shared common surface area with the conductive redistribution structures 53, 54, 55, 56 in x-y-plane, x-z-plane and/or y-z-plane, and at least one electrically conductive area, which is parallel to the main surface areas 51,52 and/or spatially extends into x and/or y direction. The matrix 60 embeds said conductive redistribution structures 53, 54, 55, 56. In particular, the horizontal electrically conductive redistribution structures 55 and the vertical electrically conductive redistribution structures 56 are completely embedded in the matrix 60.

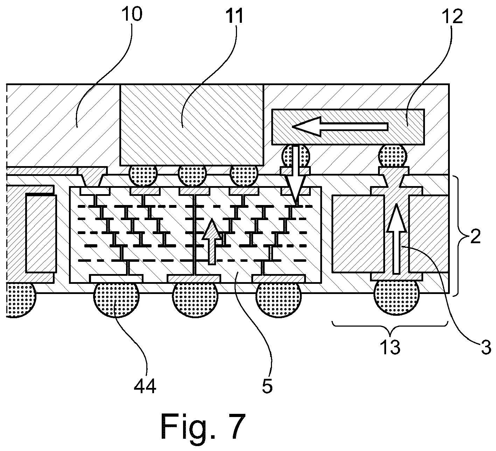

Figure 7 illustrates a cross-sectional view of a module according to an exemplary embodiment of the invention. This embodiment is a modification of the embodiment of Figure 3 and is focused on the circumstance that the bridging component 5 may act as a current providing device for the components, i.e., for the further electronic component 12 in this case. The further electronic component 11 is powered by the semiconductor-based bridging component 5 (left bottom arrow) or via detour over other components (remaining arrows). This may be helpful to safe space inside the stack and make the buildup more compact. Especially when a smaller electronic component 6, 11, 12 is attached on a bigger semiconductor based bridging component 5.

Also, the (semiconductor-based) bridging component 5 could be used as standard redistribution layer. The process of manufacturing such a redistribution layer can be simplified by embedding the bridging component 5 instead of creating a stack of fine line copper traces over many process steps. Furthermore, the CTE of the bridging component 5 is more similar compared to copper and resin containing redistribution layers, as stated in the beginning of the embodiments.

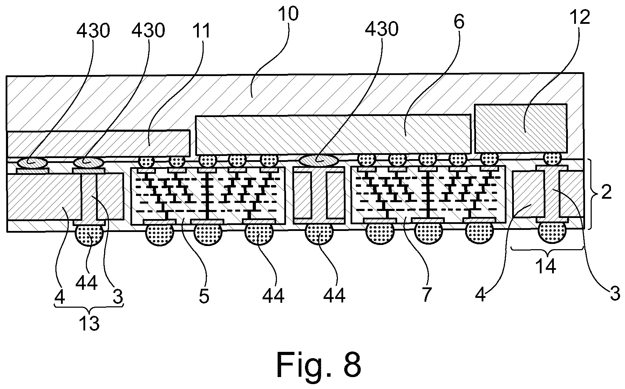

Figure 8 illustrates a cross-sectional view of a module according to an exemplary embodiment of the invention. This embodiment is a modification of the embodiment of Figure 1. The (semiconductor-based) bridging component 5 is able to connect components with different pitch sizes, or one component with different pitch sizes, or one component with one pitch size ect. In Figure 8, a distance between solder balls 430 is different from a distance between the smaller solder balls (reference sign 43 in Fig. 5).

In an embodiment, the connection of component(s) comprises different pitch sizes to the (semiconducting-based) bridging component 5, which component(s) are located either totally, or partly over the bridging component 5 regarding the z direction, or are not directly arranged over the bridging component 5 (for example the electronic component 6 in Figure 3).

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A module (1) comprising:
a component carrier (2) with a stack comprising at least one electrically conductive layer structure (3) and/or at least one electrically insulating layer structure (4), and with at least one bridging component (5) embedded in the stack and having a redistribution structure;
wherein said bridging component (5) comprises a first main surface (51) and a second main surface (52), one opposite to the other, with first contacting areas (53) provided on said first main surface (51) and second contacting areas (54) provided on said second main surface (52), said first contacting areas (53) being connected to said second contacting areas (54) through respective connection elements (55, 56) provided in said bridging component (5),
wherein at least one of said first or second contacting area (53, 54) is directly or indirectly connected to at least two electronic components (6, 11, 12).

2. The module (1) according to claim 1, wherein the component carrier (2) comprises two component carrier main surfaces (21, 22), the first and second main surfaces (51, 52) of the bridging component (5) are directly connected to a respective one of the component carrier main surfaces (21, 22).

3. The module (1) according to claim 1 or 2, wherein solder balls (43, 44) are provided on at least one of the component carrier main surfaces (21, 22), said solder balls (43, 44) being directly or indirectly connected to at least one of the first or second contacting area (53, 54) of the respective bridging component main surface (51, 52).

4. The module (1) according to anyone of the preceding claims, wherein a density per volume unit or area unit of a contacting area (53) of the first main surface (51) of the bridging component (5) is different from a density per volume unit or area unit of a contacting area (54) of the second main surface (52) of the bridging component (5), wherein preferably a density per volume unit or area unit of the contacting area (53) of the first main surface (51), which is directly connected to at least one of the at least two electronic components (6, 11, 12), is higher than a density of the contacting area (54) provided on the opposed second main surface (52).

5. The module (1) according to anyone of the preceding claims, wherein said component carrier (2) comprises at least two bridging components (5, 7) embedded in the stack, wherein at least one of the at least two electronic components (6) in the component carrier (2) is preferably connected to the at least two bridging components (5, 7), wherein further preferred each of the at least two bridging components (5, 7) comprises a first main surface, wherein the at least one of the at least two electronic components (6) is connected to each first main surface of the at least two bridging components (5, 7) facing the same component carrier main surface (21).

6. The module (1) according to anyone of the preceding claims, wherein said bridging component (5) is connected to a third electronic component, wherein said bridging component (5) is preferably connected to the third electronic component via the first main surface (51).

7. The module (1) according to anyone of the preceding claims, further comprising at least one of the following:
wherein at least one of the at least two electronic components (6) is additionally connected to a further redistribution structure directly provided in said component carrier (2);
wherein at least one of the at least two electronic components (6, 11, 12) is exclusively connected to said at least one bridging component (5);
wherein, at least one of the at least two electronic components (6, 11, 12) is partially connected to said bridging component (5);
wherein at least one of the at least two electronic components (6, 11, 12) is connected to a power conducting supplying structure for power supply to the at least one of the at least two electronic components (6, 11, 12);
wherein the bridging component (5) is configured to supply electric power to the electronic component (6);
wherein the electronic component (6) comprises at least one of a group consisting of a processor, a memory, a passive component, and a power chip;
wherein the module (1) further comprises a mold (10) encapsulating the electronic component (6).

8. The module (1) according to anyone of the preceding claims, wherein
the bridging component (5) comprises a matrix (60) of dielectric or semiconductor material and the connection elements (55, 56) embedded in the matrix, which form the electrically conductive redistribution structure together with the first and second contacting areas (53, 54), wherein a mean distance between the first contacting areas (53) is different to a mean distance between the second contacting areas (54).

9. The module (1) according to claim 8, wherein
the connection elements (55, 56) comprise at least two first horizontal electrically conductive redistribution structures (55) in an x direction, at least two second horizontal electrically conductive redistribution structures in an y direction, and at least two vertical electrically conductive redistribution structures (56) in a z direction;
at least one of said first and second horizontal electrically conductive redistribution structures is electrically connected to at least one vertical electrically conductive redistribution structure (56).

10. The module (1) according to claim 9, comprising at least one of the following features:
a mean distance between two first horizontal electrically conductive redistribution structures (55) in the x direction is different from a mean distance between two second horizontal electrically conductive redistribution structures the in the y direction and/or different from a mean distance between two vertical electrically conductive redistribution structures in the z direction; and/or
a mean distance between two second horizontal electrically conductive redistribution structures in the y direction is different from a mean distance between two vertical electrically conductive redistribution structures in the z direction.

11. The module (1) according to anyone of the preceding claims, wherein
the module (1) comprises a mounting base on which the component carrier (2) is mounted.

12. The module (1) according to anyone of the preceding claims, wherein
the bridging component (5) and a further bridging component (7), both are preferably two bridging components (5, 7), are arranged side by side in the stack at the same vertical level.

13. The module (1) according to anyone of the preceding claims, wherein the component carrier comprises at least one of the following features:
the component carrier comprises at least one component being surface mounted on and/or embedded in the component carrier, wherein the at least one component is in particular selected from a group consisting of an electronic component, an electrically non-conductive and/or electrically conductive inlay, a heat transfer unit, a light guiding element, an optical element, a bridge, an energy harvesting unit, an active electronic component, a passive electronic component, an electronic chip, an RF chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a further component carrier, and a logic chip;
wherein at least one of the electrically conductive layer structures of the component carrier comprises at least one of the group consisting of copper, aluminum, nickel, silver, gold, palladium, and tungsten, any of the mentioned materials being optionally coated with supra-conductive material such as graphene;
wherein the electrically insulating layer structure comprises at least one of the group consisting of resin, in particular reinforced or non-reinforced resin, for instance epoxy resin or bismaleimide-triazine resin, FR-4, FR-5, cyanate ester resin, polyphenylene derivate, glass, prepreg material, polyimide, polyamide, liquid crystal polymer, epoxy-based build-up film, polytetrafluoroethylene, a ceramic, and a metal oxide;
wherein the component carrier is shaped as a plate;
wherein the component carrier is configured as one of the group consisting of a printed circuit board, a substrate, and an interposer;
wherein the component carrier is configured as a laminate-type component carrier.

14. A method of manufacturing a module (1), wherein the method comprises:
providing a component carrier (2) with a stack comprising at least one electrically conductive layer structure (3) and/or at least one electrically insulating layer structure (4), and with at least one bridging component (5) embedded in the stack and having a redistribution structure;
wherein said bridging component (5) comprises a first main surface (51) and a second main surface (52), one opposite to the other, with first contacting areas (53) provided on said first main surface (51) and second contacting areas (54) provided on said second main surface (52), said first contacting areas (53) being connected to said second contacting areas (54) through respective connection elements (55, 56) provided in said bridging component (5),
wherein at least one of said first or second contacting area (53, 54) is directly or indirectly connected to at least two electronic components (6, 11, 12).

15. The method according to claim 14, wherein
the method is carried out on panel level.
